Europäisches Patentamt

European Patent Office

Office européen des brevets

(19)

(11) Publication number: **0 152 168**
**A2**

## (12) EUROPEAN PATENT APPLICATION

(21) Application number: **85300126.1**

(22) Date of filing: **08.01.85**

(51) Int. Cl.⁴: **H 01 L 23/48**

(30) Priority: **09.01.84 US 569077**

(43) Date of publication of application:
**21.08.85 Bulletin 85/34**

(84) Designated Contracting States:
**BE DE FR GB**

(71) Applicant: **WESTINGHOUSE ELECTRIC CORPORATION**
**Westinghouse Building Gateway Center**
**Pittsburgh Pennsylvania 15235(US)**

(72) Inventor: **Hunt, Thomas John**
**R.D. No. 1**
**Latrobe Pennsylvania(US)**

(74) Representative: **van Berlyn, Ronald Gilbert**
**23, Centre Heights**
**London, NW3 6JG(GB)**

(54) Contact material for compression bonded semiconductor devices.

(57) The present invention teaches the use of a nickel clad silver foil member between an aluminum ohmic contact and a nickel clad copper pole piece in a compression bonded power semiconductor device. The nickel-to-aluminum interface provides stable device operation by preventing the "battery effect" which occurs when aluminum and silver are interfaced.

FIG. 2

EP 0 152 168 A2

0152168

1
## CONTACT MATERIAL FOR COMPRESSION BONDED
## SEMICONDUCTOR DEVICES

The present invention relates generally to the field of compression bonded power semiconductor devices, and more specifically to contact materials therefor.

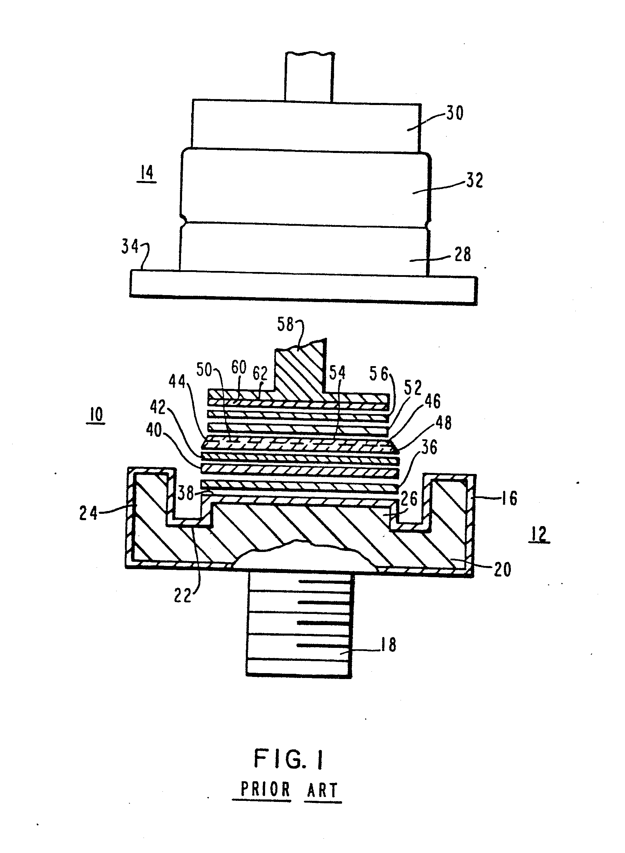

With reference to Fig. 1, there is shown an exploded view of a prior art compression bonded power semiconductor device 10..

The device 10 is comprised of a base member 12 and a cap member 14.

The base member 12 is normally comprised of copper with a nickel cladding 16. The nickel cladding is typically about 0.3 mils thick.

The base member 12 has a threaded stud portion 18 and a cup portion 20.

The cup portion 20 is comprised of a flat portion 22, a side portion 24, which extends vertically upward from the flat portion 22, and a pole portion 26.

The cap member 14 is comprised of two metal portions 28 and 30 which may be nickel clad copper separated by a ceramic or other electrically insulating portion 32.

The cap member 14 has a metal side portion 34 which is joined to the side portion 24 of the base member 12 by any suitable means such for example as brazing or soldering.

A silver preform 36 is disposed on surface 38 of pole portion 26. The silver preform 36 typically has a thickness of 3 mils.

A molybdenum electrical contact 40 is disposed on the silver preform 36. The molybdenum typically has a thickness of 60 mils.

The silver preform 36 assures good thermal and electrical contact between the pole portion 26 and molybdenum electrical contact 40. The malleability of the silver preform assures total surface-to-surface contact between the molybdenum contact 40 and the surface 38 of cup portion 20 through the preform 36.

A solder layer 42 is disposed between molybdenum contact 40 and a silicon wafer 44 and joins the wafer 44 to the molybdenum contact 40.

The solder layer 42 may be comprised of any suitable silver base hard, or lead base soft solder known to those skilled in the art.

The silicon wafer 44 is single crystal silicon and has a first region 46 of a first type of conductivity and a second region 48 of a second type of conductivity with a pn junction 50 between the regions 46 and 48.

The thickness of the silicon depends on the design parameters of the devices. For a diode having a rated voltage of 2600 volts and a 250 amp current rating, the silicon wafer will have a thickness of 21 mils.

An aluminum layer 52 is affixed to surface 54 of the silicon wafer 44. The aluminum layer 52 may be affixed to surface 54 by sputtering, vapor deposition or any other process known to those skilled in the art.

The aluminum layer 52 functions as an electrical contact to the region 46 of the wafer 44.

A silver preform 56 is disposed between the aluminum layer 52 and pole piece 58. The silver preform has a thickness of 3 mils. The pole piece 58 is comprised of copper with a 0.3 mil thick nickel layer 60 disposed on surface 62 which is in contact with silver preform 56.

In a device of the type just described a phenomenon known as the "battery effect" has been observed between the silver preform 56 and the aluminum layer 52. This battery effect is due to the relative position of aluminum and silver in the Electromotive Series of the Metals, aluminum, which is sixth in the series, and silver, which is twentieth, being under pressure, from the compression bonding means, and being heated from the current flow through the devices and moisture within the case member.

The battery effect causes the forward voltage drop of the devices to increase during operation of the device. It is the principal object of the invention to reduce the battery effect.

The invention resides broadly in a compression bonded power semiconductor device in which a malleable preform is disposed between an aluminum electrical contact affixed to one region of a silicon wafer and a pole piece, the improvement comprising, employing a malleable preform comprising nickel clad silver.

For a better understanding of the present invention, reference should be had to the following detailed discussion and Figures, of which:

Figure 1 is an exploded view of a prior art compression bonded power semiconductor device, and

Figure 2 is an exploded view of a compression bonded power semiconductor device setting forth the teaching of the present invention.

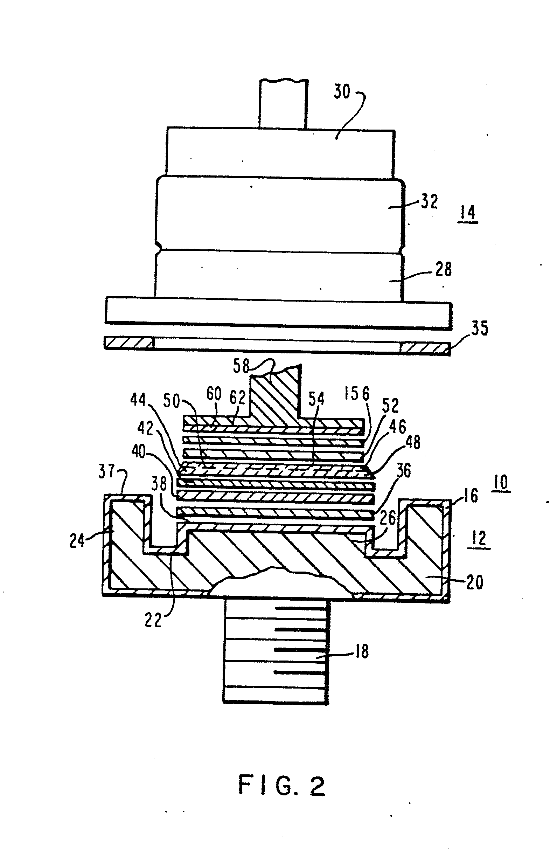

With reference to Fig. 2, there is shown an exploded view of a compression bonded power semiconductor device 110 setting forth the teachings of this invention.

The invention will be described in terms of a diode or rectifier having a rated voltage of 2600 volts and an average current rating of 2500 amps.

The diode of Fig. 2 is essentially identical to the diode of Fig. 1 except at the point of invention and the same numbers will be used to denote the same components.

4 0152168

The device 10 is comprised of a base member 12 and a cap member 14.

The base member 12 is comprised of copper with a nickel cladding 16. The nickel cladding has a thickness of approximately 0.3 mils.

The base member 12 has a threaded stud portion 18 and a cup portion 20.

The cup portion 20 is comprised of a flat portion 22, a side portion 24, which extends vertically upward from the flat portion 22, and a pole piece or portion 26.

The cap member 14 is comprised of two metal portions 28 and 30 which are nickel clad copper separated by a ceramic or other electrically insulating material portion 32.

The cap member 14 has a metal side portion 34 and is joined by a solder layer 35 to surface 37 of side portion 24 of the base member 12.

A silver preform 36 is disposed on surface 38 of pole piece or portion 26. The silver preform 36 has a thickness of 3 mils.

A molybdenum electrical contact, the cathode contact, 40 is disposed on the silver preform 36. The molybdenum contact 40 has a thickness of 60 mils.

The silver preform 36 assures good thermal and electrical contact between the pole piece 26 and the molybdenum electrical contact 40. The malleability of the silver preform compensates for any surface irregularities between the pole piece 26 and the molybdenum contact 40 and assures total surface-to-total surface contact through the preform 36.

A solder layer 42 disposed between the molybdenum contact 40 and silicon wafer 44 joins the contact 40 to the wafer in a thermal and ohmic electrical contact relationship.

The solder layer 42 is a silver base solder of the type known to those skilled in the art as a hard solder.

The silicon wafer 44 is of single crystal silicon and has a p-type region 46 and an n-type region 48 with a pn junction 50 between regions 46 and 48.

The silicon wafer has a thickness of 21 mils and a diameter of 1.25 inches.

An aluminum layer 52 is affixed to surface 54 of the silicon wafer 44 and functions as an anode ohmic electrical contact. The aluminum layer 52 may be deposited on surface 54 by sputtering, vapor deposition or any other process known to those skilled in the art.

A preform 156 is disposed between the aluminum layer 52 and a pole piece 58.

The preform 156 has a total thickness of 3 mils and is comprised of a central portion consisting of silver with a thickness of 2.7 mils and a cladding of nickel which completely surrounds the silver central portion. The nickel cladding has a thickness of 0.3 mil.

The nickel cladding on the preform prevents the battery effect between the aluminum and the silver. However, the nickel cladding is thin enough so that the preform exhibits the malleability of the silver and assures total surface-to-total surface contact between the aluminum contact layer 52 and the pole piece 58 through the preform 156.

The minimum thickness of the nickel cladding is that thickness which prevents the electromotive effect between aluminum and silver. A nickel cladding thickness of 0.1 mil is effective and the thickness of the nickel cladding may be as thin as 0.05 mil.

The maximum thickness of the nickel cladding is one mil. If the cladding exceeds one mil, the desired malleability property of the silver is not fully realized.

The most satisfactory results have been realized with a preform having a total thickness of 3 mils with the nickel cladding being 0.3 mil thick and the silver being 2.7 mils thick, and the silver having a hardness of 36 DPN (diamond point number) and the nickel having a hardness of 33 DPN.

The desired silver and nickel hardness can be realized by first forming the preform by cold rolling a nickel foil onto a silver foil and then annealing the preform at a temperature of from 500°C to 550°C in a hydrogen atmosphere for a period of time ranging 10 to 20 minutes.

The method holding the components under compression within the case which is comprised of the base member 12 and the cap member 14 may be any method known to those skilled in the art.

Two diodes were prepared. One diode was made in accordance with the teachings of this invention using a nickel clad silver preform between the aluminum anode contact and the pole piece and the other diode was made using only a silver preform, of the same thickness as the nickel clad silver preform, between the aluminum anode contact and the pole piece.

The two diodes were then tested for forward voltage drop.

The diode with the nickel clad silver preform was tested three times and in each test had a forward voltage drop of 1.5 volts.

The diode with the silver preform was tested three times, during the first test it showed a forward voltage drop of 1.5 volts, during the second test the forward voltage drop was 1.8 volts and the third test showed a forward voltage drop of 2.1 volts.

The tests clearly show that there was no "battery effect" in the device containing the nickel clad silver preform while the "battery effect" was obvious in the device containing the silver preform between the aluminum anode contact and the pole piece.

In testing of devices containing silver preforms, rather than the nickel clad silver preform of this invention, frequently show a change in forward voltage drop of 400 to 500 millivolts in a span of three tests and increases of 25% in the forward voltage drop over a span of three tests is commonplace.

However, devices made using the nickel clad silver preform of this invention normally do not show any increase in forward voltage drop in a span of three tests.

8

Claims:

1. A compression bonded power semiconductor device (10) in which a malleable preform (156) is disposed between an aluminum electrical contact (52) affixed to one region of a silicon wafer (44) and a pole piece (58), characterized in that said malleable preform (156) comprises nickel clad silver.

2. A device of claim 1 characterized in that the nickel cladding has a thickness of from 0.05 mil to 1.0 mil.

3. A device of claims 1, 2 characterized in that the nickel has a hardness of 33 DPN and the silver has a hardness of 36 DPN.

4. A device of claim 1, 2 or 3, characterized in that the nickel cladding has a thickness of 0.3 mil.

FIG. 1

PRIOR ART

FIG. 2